# EUROPEAN PATENT SPECIFICATION

(11) **EP 2 065 487 B1**
(45) Date of publication and mention of the grant of the patent: **09.01.2013**
(21) Application number: 08019622.3
(22) Date of filing: 10.11.2008
(51) Int. Cl.: C23C 14/56

(54) **In-line film-formation apparatus**
Lineare Verdampfvorrichtung
Appareil de formation de film en ligne

(30) Priority: 21.11.2007 JP 2007301191
(43) Date of publication of application: 03.06.2009
(73) Proprietor: Mitsubishi Heavy Industries, Ltd., Tokyo 108-8215 (JP)
(72) Inventor: Kamikawa, Susumu, Hiroshima-shi, Hiroshima (JP); Sato, Keiichi, Hiroshima-shi, Hiroshima (JP); Kitamoto, Hiroko, Hiroshima-shi, Hiroshima (JP); Kobayashi, Toshiro, Hiroshima-shi, Hiroshima (JP)
(74) Representative: Strehl Schübel-Hopf & Partner

(56) References cited:
- EP-A- 1 260 605
- EP-A- 1 632 586
- WO-A-00/43119
- WO-A-2005/086238
- JP-A- 2 125 866

## Description

### BACKGROUND OF THE INVENTION

### 1. Field of the Invention

The present invention relates to an in-line film-formation apparatus equipped with a co-deposition chamber in which multiple film-formation materials are either evaporated or sublimed, and are then deposited mixedly onto a substrate to form a film.

### 2. Description of the Related Art

A co-deposition film-formation apparatus has been known in which multiple film-formation materials are either evaporated or sublimed, and are then deposited mixedly onto a substrate to form a film. For example, in the case of forming the light-emitting layer of the organic electroluminescence (EL) device and the like using such a co-deposition film-formation apparatus, the film formation has to be done by the following procedure. While a glass substrate is being conveyed, multiple film-formation materials that are evaporated or sublimed are sprayed out from multiple nozzles located at the lower side of the glass substrate, and are then mixed together at a predetermined proportion. The film-formation materials thus mixed are deposited on the glass substrate so as to form a film thereon. An apparatus disclosed in Japanese Patent Application Publication No. 2002-348659 is a specific example of the above-mentioned co-deposition film-formation apparatus, and the disclosed apparatus mixes film-formation materials and form a film in the following way. Containers that can be tilted are provided to the apparatus to contain film-formation materials respectively. The angles of these containers are adjusted to take positions that allow the co-deposition of their respective film-formation materials in a single deposition region. Another example of the co-deposition film-formation apparatus is disclosed in Japanese Patent Application Publication No. 2006-057173. Multiple containers containing different film-formation materials are provided in the disclosed apparatus, and the nozzles of the multiple containers are alternately arranged in the width directions of the glass substrate (i.e., in a direction perpendicular to the direction in which the glass substrate is conveyed). Then, co-deposition is performed by mixing together the film-formation materials that have been sprayed out from the nozzles to form a film.

An in-line film-formation apparatus has been known in which multiple layers of films including a mixed film that contains multiple film-formation materials are successively formed on a glass substrate that is conveyed at a constant speed. Japanese Patent Application Publications No. Hei 10-140351, No. 2002-176090, and No. Hei 02-125866 <see, Fig. 5> disclose such in-line film-formation apparatuses. In each of these in-line film-formation apparatuses, a series of deposition chambers are disposed successively in the direction in which the glass substrate is conveyed (hereafter, simply referred to as the glass-substrate conveying direction, or the conveying direction). In order to form a multi-layered film, the apparatus is provided with deposition-preventing plates that partition the multiple deposition chambers. The deposition-preventing plates prevent the mixing of vapor of different kinds of film-formation materials being let out from deposition sources of the deposition chambers that are adjacent to each other.

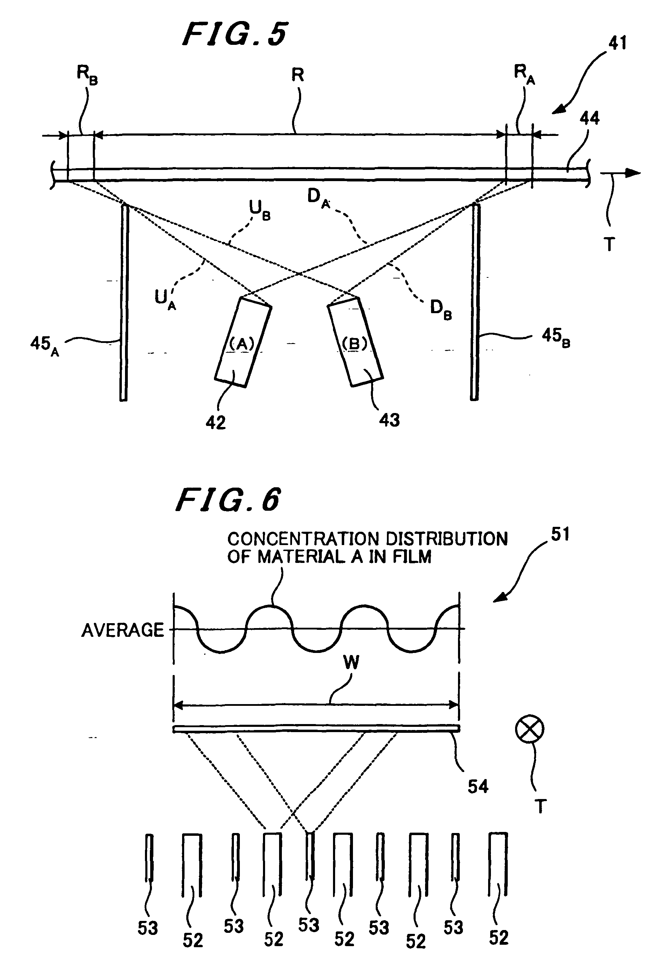

Fig. 5 shows an exemplary configuration of the co-deposition chamber provided in a conventional in-line film-formation apparatus. In a co-deposition chamber 41, containers 42 and 43 are provided to store film-formation materials A and B respectively. A glass substrate 44 is conveyed in a conveying direction T. The film-formation materials A and B are respectively released from the containers 42 and 43 to perform the co-deposition of the film-formation materials A and B onto the glass substrate 44. In this event, deposition-preventing plates 45_{A} and 45_{B} are used to partition the co-deposition chamber 41. Suppose a case where a mixed film is formed by use of the apparatus with such a configuration. In this case, a mixed film of the film-formation materials A and B can be obtained within a deposition region R on the glass substrate 44 while the deposition-preventing plates 45_{A} and 45_{B} do not have any influence on the co-deposition of the film-formation materials A and B. By contrast, a mono-content film of either one of the film-formation materials A and B is formed in each of deposition regions R_{A} and R_{B} located, on the glass substrate, respectively at the downstream and upstream sides of the deposition region R in the conveying direction. In other words, no mixed film can be obtained in these regions due to the geometrical positions of the nozzles of the containers 42 and 43 with respect to the deposition-preventing plates 45_{A} and 45_{B}. The formation of such a mono-content film in the production of the organic EL device causes such problems as the necessity of a larger voltage for emitting light in the electron-injection layer, which may possibly lead eventually to a lower luminous efficiency.

The mechanism of forming a mono-content film will be described below with reference to Fig. 5. The deposition-preventing plate 45_{A} restricts, on the upstream side, the deposition of the film-formation material A released from the container 42 within a region defined by a line U_{A}. On the other hand, the deposition-preventing plate 45_{A} also restricts, on the upstream side, the deposition of the film-formation material B released from the container 43 within a region defined by a line U_{B}. The deposition region R_{B} thus formed is included in the deposition region of the film-formation material B of the container 43, but is not included in the deposition region of the film-formation material A of the container 42. As a consequence, the film thus formed in the deposition region R_{B} becomes a mono-content film of the film-formation material B. Likewise, the deposition-preventing plate 45_{B} restricts, on the downstream side, the deposition of the film-formation material A released from the container 42 within a region defined by a line D_{A}. On the other hand, the deposition-preventing plate 45_{B} also restricts, on the downstream side, the deposition of the film-formation material B released from the container 43 within a region defined by a line D_{B}. The deposition region R_{A} thus formed is included in the deposition region of the film-formation material A of the container 42, but is not included in the deposition region of the film-formation material B of the container 43. As a consequence, the film thus formed in the deposition region R_{A} becomes a mono-content film of the film-formation material A. Thus, a problem arises in which not a mixed film but a mono-content film is formed, both on the upstream side and on the downstream side in the conveying direction T of the glass substrate 44. For this reason, the distance between every two deposition chambers must be elongated, which leads eventually to a larger apparatus as a whole.

Fig. 6 shows the configuration of the apparatus disclosed in Japanese Patent Application Publication No. 2006-057173. In a co-deposition chamber 51, multiple containers 52 and 53 are provided to store film-formation materials A and B. The nozzles of the multiple containers 52 and 53 are alternately arranged in substrate-width directions W of a glass substrate 54 (i.e., a direction perpendicular to the glass-substrate conveying direction T). The film-formation materials A and B released from the nozzles thus arranged are mixed to perform the co-deposition. This configuration, accordingly, is unlikely to cause the above-described problem of forming a mono-content film. Nonetheless, the above-described configuration with the nozzles of the containers 52 and 53 being arranged alternately in the substrate-width directions W causes another problem that the film-formation materials are unevenly distributed in terms of their densities in the substrate-width directions W as Fig. 6 shows. Different film-formation materials have to be heated up to different temperatures so as to be evaporated or sublimed. In addition, different film-formation rates require different temperatures. Accordingly, the nozzles of the evaporation containers 52 and 53 have to be heated up to different temperatures. In addition, a space is needed between every two adjacent nozzles to insulate thermally. The need for such thermal insulation requires a larger distance between the nozzles. As a consequence, the uneven concentration distribution in the substrate-width directions is increased.

As has been described thus far, co-deposition by a conventional in-line film-formation apparatus inevitably causes such problems as the formation of a mono-content film and the producing of uneven concentration distribution.

### SUMMARY OF THE INVENTION

The present invention has been made in view of the problems described above. An object of the present invention is providing an in-line film-formation apparatus which is capable of performing co-deposition without causing formation of a mono-content film or producing any uneven concentration distribution.

A first aspect of the present invention to achieve the above-mentioned object provides an in-line film-formation apparatus including a plurality of deposition chambers at least one of which is a co-deposition chamber that forms a mixed film by a co-deposition process of two different film-formation materials, in the co-deposition process the two different film-formation materials being evaporated or sublimed and then the vapor of the evaporated or sublimed two film-formation materials being mixedly deposited, the plurality of deposition chambers being arranged in a conveying direction in which a substrate is conveyed, the deposition chambers thus arranged forming films successively onto the substrate that is being conveyed, so as to form a multi-layered film onto the substrate. In the in-line film-formation apparatus, the co-deposition chamber includes: two deposition sources that respectively store the film-formation materials, the deposition sources respectively including openings each extending in the width directions of the substrate which are perpendicular to the conveying direction, the openings being arranged in parallel with each other respectively on the upstream and downstream sides in the conveying direction; two partition members that partition the co-deposition chamber respectively from adjacent deposition chambers, the partition members being placed away from the conveyed substrate and being placed in parallel with each other respectively on the upstream and downstream sides in the conveying direction with the two deposition sources placed in between; and a restriction member that restricts vapor released from the upstream-side opening and deposited on the downstream side of the substrate so that a downstream-side limit is set on a deposition region where the vapor is to be deposited, the deposition region with the downstream-side limit coinciding with a deposition region of vapor released from the downstream-side opening and deposited on the downstream side of the substrate, the partition member on the downstream side setting a downstream-side limit on the deposition region of the vapor released from the downstream-side opening, and while the formation of a mono-content film containing either one of the two film-formation materials is prevented on the downstream side of the substrate, only the mixed film is formed on the downstream side of the substrate.

A second aspect of the present invention to achieve the above-mentioned object provides the in-line film-formation apparatus according to the first aspect with the following characteristic features. The restriction member further restricts the vapor released from the downstream-side opening and deposited on the upstream side of the substrate so that an upstream-side limit is set on the deposition region of the vapor released from the downstream-side opening, and the deposition region of the vapor released from the downstream-side opening with the upstream-side limit coincides with a deposition region of vapor released from the upstream-side opening and deposited on the upstream side of the substrate while the upstream-side partition member sets an upstream-side limit on the deposition region of the vapor released from the upstream-side opening, and while the formation of a mono-content film containing either one of the two film-formation materials is prevented also on the upstream side of the substrate, only the mixed film is formed on the upstream side of the substrate.

A third aspect of the present invention to achieve the above-mentioned object provides the in-line film-formation apparatus according to the first and second aspects with the following characteristic features. The in-line film-formation apparatus comprises a screen a screen which is disposed between the two openings and which serves as the restriction member.

A fourth aspect of the present invention to achieve the above-mentioned object provides the in-line film-formation apparatus according to the third aspect with the following characteristic features. The screen is placed so that the upper end of the screen is on at least one of a first and a second lines defined as follows: the first line which is drawn from a starting point through the farther one of the edges of the upstream-side opening from the downstream-side partition member, the starting point being an intersection of the substrate with a line passing through the tip of the downstream-side partition member and the farther one of the edges of the downstream-side opening from the downstream-side partition member; and the second line which is drawn from a starting point through the farther one of the edges of the downstream-side opening from the upstream-side partition member, the starting point being an intersection of the substrate with a line passing through the tip of the upstream-side partition member and the farther one of the edges of the upstream-side opening from the upstream-side partition member.

A fifth aspect of the present invention to achieve the above-mentioned object provides the in-line film-formation apparatus according to the first and second aspects with the following characteristic features. At least one of opening side walls defined as follows is extended so as to serve as the restriction member: one of the two opening side walls of the upstream-side opening, the one being located closer to the downstream-side opening; and one of the two opening side walls of the downstream-side opening, the one being located closer to the upstream-side opening.

A sixth aspect of the present invention to achieve the above-mentioned object provides the in-line film-formation apparatus according to the fifth aspect with the following characteristic features. The opening side wall is formed with the top face of at least one of the openings obliquely formed so as to accomplish any one of a first coincidence and a second coincidence defined as follows: the first coincidence being between the position of the top face of the upstream-side opening and a line which is drawn from a starting point through the upper end of the upstream-side opening, the starting point being an intersection of the substrate with a line passing through the upper end of the downstream-side opening and the tip of the downstream-side partition member; and the second coincidence being between the position of the top face of the downstream-side opening and a line which is drawn from a starting point through the upper end of the downstream-side opening, the starting point being an intersection of the substrate with a line passing through the upper end of the upstream-side opening and the tip of the upstream-side partition member.

A seventh aspect of the present invention to achieve the above-mentioned object provides the in-line film-formation apparatus according to the sixth aspect with the following characteristic features. The top face is obliquely formed by cutting the opening.

An eighth aspect of the present invention to achieve the above-mentioned object provides an in-line film-formation apparatus including a plurality of deposition chambers at least one of which is a co-deposition chamber that forms a mixed film by a co-deposition process of two different film-formation materials, in the co-deposition process the two different film-formation materials being evaporated or sublimed and then the vapor of the evaporated or sublimed two film-formation materials being mixedly deposited, the plurality of deposition chambers being arranged in a conveying direction in which a substrate is conveyed, the deposition chambers thus arranged forming films successively onto the substrate that is being conveyed, so as to form a multi-layered film onto the substrate. In the in-line film-formation apparatus, the co-deposition chamber includes: two deposition sources that respectively store the film-formation materials, the deposition sources respectively including openings each extending in the width directions of the substrate which are perpendicular to the conveying direction, the openings being arranged in parallel with each other respectively on the upstream and downstream sides in the conveying direction; two partition members that partition the co-deposition chamber respectively from adjacent deposition chambers, the partition members being placed away from the conveyed substrate and being placed in parallel to each other respectively on the upstream and downstream sides in the conveying direction with the two deposition sources placed in between; and restriction members that restrict vapor released from a first-side one of the openings on a first side of the upstream and downstream sides and deposited on a second side of the upstream and downstream sides of the substrate so that a second-side limit is set on a deposition region where the vapor is to be deposited, the deposition region with the second-side limit coinciding with a deposition region of vapor released from a second-side one of the openings on the second side and deposited on the second side of the substrate, a second one of the partition members on the second side setting a second-side limit on the deposition region of the vapor released from the second-side one of the openings, opening side walls, extending on the second sides of the respective openings, are formed as the restriction members by obliquely forming the top faces of the openings so that the top faces of the openings are on a line which passes through the upper end of the second-side one of the openings and the tip of the second one of the partition members, and while the formation of a mono-content film containing either one of the two-film-formation materials is prevented on the second side of the substrate, only the mixed film is formed on the second side of the substrate.

The ninth aspect of the present invention provides the in-line film-formation apparatus according to the eighth aspect with the following characteristic features. The in-line film-formation apparatus further includes a thermal insulation member provided between the two deposition sources. In addition, the two deposition sources are placed closely to each other.

According to the present invention, in the co-deposition chamber, the restriction member sets a limit on the deposition region of the vapor either from any one of or from both of the deposition sources. For this reason, the formation of a mono-content film can be avoided either on any one of or on both of the upstream side and the downstream side, in the conveying direction, of the substrate. In addition, co-deposition without any unevenness in density can be accomplished not only in the conveying direction, but also in the width directions of the substrate, which is perpendicular to the conveying direction. The restriction member to set a limit on the deposition region of the vapor either from any one of or from both of the deposition sources allows the adjacent deposition chambers to be placed more closely to one another. Accordingly, the in-line film-formation apparatus which is shorter and more compact can be formed.

### BRIEF DESCRIPTION OF THE DRAWINGS

Fig. 1 is a schematic view illustrating an in-line film-formation apparatus according to a first embodiment of the present invention.
Fig. 2 is a schematic view illustrating an in-line film-formation apparatus according to a second embodiment of the present invention.
Fig. 3 is a schematic view illustrating an in-line film-formation apparatus according to a third embodiment of the present invention.
Fig. 4 is a schematic view illustrating an in-line film-formation apparatus according to a fourth embodiment of the present invention.
Fig. 5 is a schematic view illustrating a co-deposition chamber of a conventional in-line film-formation apparatus.
Fig. 6 is a schematic view illustrating a co-deposition chamber of another conventional in-line film-formation apparatus.

### DETAILED DESCRIPTION OF THE INVENTION

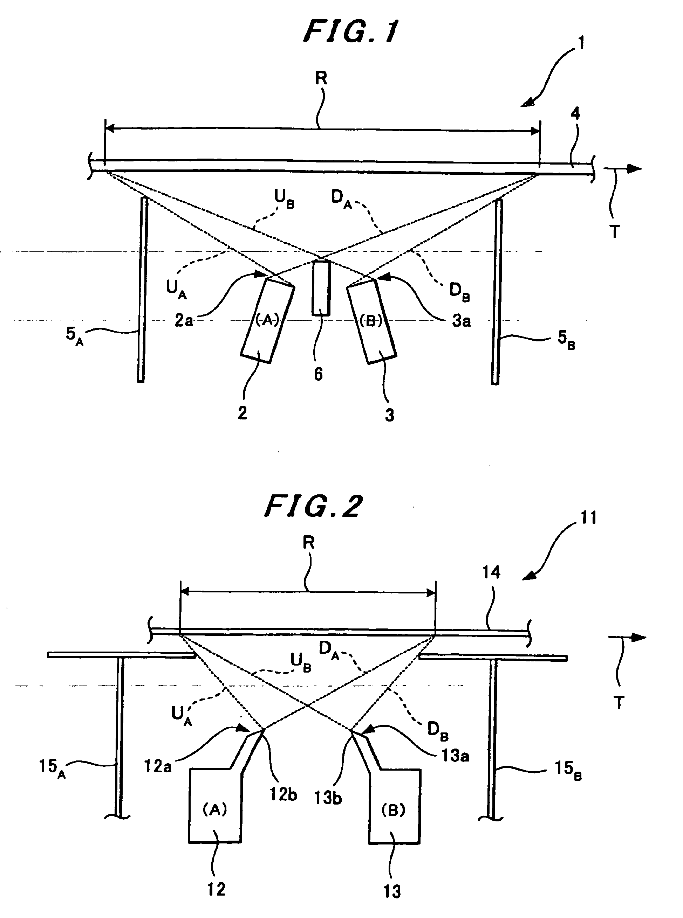

An in-line film-formation apparatus according to some embodiments of the present invention will be described below with reference to Figs. 1 to 4.

### Embodiment 1

Fig. 1 is a schematic view illustrating an in-line film-formation apparatus according to a first embodiment of the present invention. Fig. 1 used for the description of this embodiment illustrates only a co-deposition chamber to form a mixed film of all the multiple deposition chambers constituting the in-line film-formation apparatus.

The in-line film-formation apparatus according to this embodiment of the present invention has multiple deposition chambers. At least one of the multiple deposition chambers is a co-deposition chamber to perform a co-deposition process in which two different film-formation materials, either evaporated or sublimed, are deposited mixedly to form a mixed film. The multiple deposition chambers are arranged in a direction in which a substrate is conveyed. While the substrate is being conveyed at a constant speed, films are successively formed respectively by the multiple deposition chambers. As a consequence, multi-layered films are thus formed on the substrate while the mixed film formed of multiple film-formation materials is included in those multi-layered films. Each of the in-line film-formation apparatuses according to a second embodiment to a fourth embodiment, which will be described later, has a similar configuration.

As Fig. 1 shows, the in-line film-formation apparatus of this embodiment has at least one co-deposition chamber 1, and the co-deposition chamber 1 includes two deposition sources 2 and 3 that respectively store film-formation materials A and B. Openings 2a and 3a are formed respectively in the deposition sources 2 and 3. Each of the openings 2a and 3a extends in the width directions of a glass substrate 4, which is perpendicular to a conveying direction T of the glass substrate 4. The openings 2a and 3a are arranged in parallel with each other and are disposed respectively on the upstream side and on the downstream side in the conveying direction T. Co-deposition is performed firstly by either evaporating or subliming the film-formation materials A and B stored respectively in the deposition sources 2 and 3. Then, the film-formation materials A and B, either evaporated or sublimed, are mixedly deposited, so as to form a mixed film, onto the glass substrate 4 that is conveyed in the conveying direction T. The length of each of the openings 2a and 3a in the width directions of the glass substrate 4, which is a direction perpendicular to the conveying direction T, is preferably equal to or longer than the width of the glass substrate 4. In Fig. 1, each of the openings 2a and 3a has a top face that is inclined with respect to the surface (the bottom surface) of the glass substrate 4. However, the top surface of each of the openings 2a and 3a may be parallel to the surface of the glass substrate 4, or may be inclined in other ways than what is shown in Fig. 1.

Two deposition-preventing plates 5_{A} and 5_{B} (partition members) are disposed in the co-deposition chamber 1 so that the deposition-preventing plates 5_{A} and 5_{B} can partition the co-deposition chamber 1 respectively from its adjacent deposition chambers. The deposition-preventing plates 5_{A} and 5_{B} are placed so as to be separated away from the conveyed glass substrate 4. The deposition-preventing plates 5_{A} and 5_{B} are placed in parallel to each other and are placed respectively at the upstream side and at the downstream side, in the conveying direction T, while interposing two deposition sources 2 and 3 in between. The in-line film-formation apparatus has multiple deposition chambers that are successively placed in the conveying direction T. Thus, the deposition-preventing plates 5_{A} and 5_{B} are provided to partition the deposition chambers, and to prevent the vapor from the deposition sources of adjacent deposition chambers from being mixed together.

In addition, the co-deposition chamber 1 of this embodiment is provided with a screen 6 (restriction member) between the openings 2a and 3a. Without the screen 6 as in the above-described case, the geometrical positions of the opening 2a of the deposition source 2 and the opening 3a of the deposition source 3 with respect to the deposition-preventing plates 5_{A} and 5_{B} result in the formation of a mono-content film of either one of the film-formation materials A and B on each of the upstream and downstream sides in the conveying direction T. The provision of the screen 6 in this embodiment eliminates the possibility of forming such a mono-content film in a deposition region R of the glass substrate 4. Thus, only the mixed film containing both of the film-formation materials A and B can be obtained. The mechanism that makes it possible to obtain only the mixed film will be described below with reference to Fig. 1.

The travel of the vapor released from the opening 3a of the deposition source 3 to the downstream side in the conveying direction T is restricted by the deposition-preventing plate 5_{B} within a region defined by a line D_{B}. Meanwhile, the travel of the vapor released from the opening 2a of the deposition source 2 to the downstream side in the conveying direction T is restricted by the screen 6 within a region defined by a line D_{A}. The screen 6 is placed so that the deposition region defined by the line D_{A} on the surface of the glass substrate 4 can coincide with the deposition region defined by the line D_{B} on the surface of the glass substrate 4. To be more specific, the position of the screen 6 is determined in the following way. Draw a straight line passing through the tip of the deposition-preventing plate 5_{B} from the farther one of the edges of the opening 3a of the deposition source 3 from the deposition-preventing plate 5_{B}. The line thus drawn is the line D_{B}. Draw another straight line from the intersection of the line D_{B} with the glass substrate 4 so as to pass through the farther one of the edges of the opening 2a of the deposition source 2 from the deposition-preventing plate 5_{B}. The line thus drawn is the line D_{A}. The screen 6 is placed so that the upper end of the screen 6 may be on the line D_{A}. This way of placing the screen 6 makes the deposition region of the film-formation material A coincide with the deposition region of the film-formation material B on the downstream side of the glass substrate 4 (i.e., on the downstream-side portion within the deposition region R). As a consequence, the formation of a mono-content film containing either one of the film-formation materials A and B can be avoided, and only the mixed film containing both of the film-formation materials A and B can be formed.

Likewise, the travel of the vapor released from the opening 2a of the deposition source 2 to the upstream side in the conveying direction T is restricted by the deposition-preventing plate 5_{A} within a region defined by a line U_{A}. Meanwhile, the travel of the vapor released from the opening 3a of the deposition source 3 to the upstream side in the conveying direction T is restricted by the screen 6 within a region defined by a line U_{B}. The screen 6 is placed so that the deposition region defined by the line U_{B} on the surface of the glass substrate 4 can coincide with the deposition region defined by the line U_{A} on the surface of the glass substrate 4. To be more specific, the position of the screen 6 is determined in the following way. Draw a straight line passing through the tip of the deposition-preventing plate 5_{A} from the farther one of the edges of the opening 2a of the deposition source 2 from the deposition-preventing plate 5_{A}. The line thus drawn is the line U_{A}. Draw another straight line from the intersection of the line U_{A} with the glass substrate 4 so as to pass through the farther one of the edges of the opening 3a of the deposition source 3 from the deposition-preventing plate 5_{A}. The line thus drawn is the line U_{B}. The screen 6 is placed so that the upper end of the screen 6 may be on the line U_{B}. This way of placing the screen 6 makes the deposition region of the film-formation material A coincide with the deposition region of the film-formation material B on the upstream side of the glass substrate 4 (i.e., on the upstream-side portion within the deposition region R), as well. As a consequence, the formation of a mono-content film containing either one of the film-formation materials A and B can be avoided, and only the mixed film containing both of the film-formation materials A and B can be formed.

The screen 6 traps the film-formation materials A and B, and thus becomes a barrier to shield some regions of the surface of the glass substrate 4 from the deposition of the vapor of different kinds of film-formation materials A and B released respectively from the opening 2a of the deposition source 2 and from the opening 3a of the deposition source 3. As a consequence, the screen 6 prevents the formation of any mono-content film. For this reason, the screen 6 is preferably kept capable of trapping the film-formation materials A and B. To put it differently, the screen 6 is preferably kept at a temperature that is lower enough to prevent the film-formation materials A and B from being evaporated. In addition, the screen 6 is preferably placed in the central position, in the conveying direction T, of the co-deposition chamber 1. Then, the opening 2a of the deposition source 2 and the opening 3a of the deposition source 3 are preferably placed symmetrically with respect to the position of the screen 6, and the deposition-preventing plates 5_{A} and 5_{B} are preferably also placed symmetrically with respect to the position of the screen 6. Thereby, the above-described geometrical placement positions allow the lines U_{A}, U_{B}, D_{A}, and D_{B} to be set more easily. In addition, to make the adjustment of the lines U_{A}, U_{B}, D_{A}, and D_{B} possible, the thickness of the screen 6 may be made thicker, or multiple pieces of the screen 6 may be used. Still alternatively, to make the adjustment of the lines U_{A}, U_{B}, D_{A}, and D_{B} possible, the screen 6 may be made movable both in the vertical and the horizontal directions.

As has been described thus far, the screen 6 is disposed at an appropriate position with respect to the opening 2a of the deposition source 2 and to the opening 3a of the deposition source 3. Accordingly, the formation of a mono-content film containing either one of the film-formation materials A and B can be avoided and the entire deposition region R of the glass substrate 4 can have only the mixed film containing both of the film-formation materials A and B.

In addition, the prevention of the formation of a mono-content film eliminates the necessity of elongating the distance between adjacent deposition chambers, so that the size of the apparatus as a whole can be made more compact.

It should be noted that, the screen 6 of this embodiment serves as a restriction member which restricts the deposition regions of the vapor of different kinds of film-formation materials A and B released respectively from the opening 2a of the deposition source 2 and from the opening 3a of the deposition source 3. However, there may be a case where the formation of a mono-content film is allowable on either one of the upstream side and the downstream side in the conveying direction T. In this case, the screen 6 may restrict the deposition region of the vapor released from either one of the opening 2a of the deposition source 2 and the opening 3a of the deposition source 3 as in the cases of Embodiments 3 and 4, which will be described later.

### Embodiment 2

Fig. 2 is a schematic view illustrating an in-line film-formation apparatus according to a second embodiment of the present invention. Fig. 2 used for the description of this second embodiment illustrates, as in the case of Embodiment 1, only a co-deposition chamber of all the multiple deposition chambers constituting the in-line film-formation apparatus.

As Fig. 2 shows, the in-line film-formation apparatus of this second embodiment has at least one co-deposition chamber 11, and the co-deposition chamber 11 includes two deposition sources 12 and 13 that store respectively film-formation materials A and B. Openings 12a and 13a are formed respectively in the deposition sources 12 and 13. Each of the openings 12a and 13a extends in the width directions of a glass substrate 14, which is perpendicular to a conveying direction T of the glass substrate 14. The openings 12a and 13a are arranged in parallel with each other and are disposed respectively on the upstream side and on the downstream side in the conveying direction T. Co-deposition is performed firstly by either evaporating or subliming the film-formation materials A and B stored respectively in the deposition sources 12 and 13. Then, the film-formation materials A and B, either evaporated or sublimed, are mixedly deposited so that a mixed film can be formed onto the glass substrate 14 that is conveyed in the conveying direction T. The length of each of the openings 12a and 13a in the width directions of the glass substrate 14, which is a direction perpendicular to the conveying direction T, is preferably equal to or longer than the width of the glass substrate 14.

Two deposition-preventing plates 15_{A} and 15_{B} (partition members) are disposed in the co-deposition chamber 11 so that the deposition-preventing plates 15_{A} and 15_{B} can partition the co-deposition chamber 11 respectively from its adjacent deposition chambers. The deposition-preventing plates 15_{A} and 15_{B} are placed so as to be separated away from the conveyed glass substrate 14, are placed in parallel to each other, and are placed respectively at the upstream side and at the downstream side, in the conveying direction T, while interposing the two deposition sources 12 and 13 in between. The in-line film-formation apparatus has multiple deposition chambers that are successively placed in the conveying direction T. Thus, the deposition-preventing plates 15_{A} and 15_{B} are provided to partition the deposition chambers, and prevent the vapor from the deposition sources of adjacent deposition chambers from being mixed together.

In Embodiment 1, a screen is provided between the two openings of the deposition sources so as to serve as a restriction member. In this second embodiment, however, one of the side walls of each of the opening 12a of the deposition source 12 and the opening 13a of the deposition source 13 is extended so as to serve as a restriction member. Of the two side walls of each of the openings 12a and 13a, the extended one is located on the side that is closer to the other opening. Specifically, as Fig. 2 shows, in the opening 12a, the extended side wall is located on the side closer to the opening 13a, and is referred to as an opening side wall 12b. In the opening 13a, the extended side wall is located on the side closer to the opening 12a, and is referred to as an opening side wall 13b. Note that, the simplest structure to function as restriction members may be achieved by extending only the opening side walls 12b and 13b. In this second embodiment, however, the top face of each of the openings 12a and 13a is obliquely formed to form the opening side walls 12b and 13b. When the top face of each of the openings 12a and 13a is obliquely formed, the opening of each of the deposition sources 12 and 13 may be cut so as to form the top face located at an appropriate position, which will be described later.

Accordingly, the extending of the opening side walls 12b and 13b eliminates the possibility of forming such a mono-content film in a deposition region R of the glass substrate 14. Thus, only the mixed film containing both of the film-formation materials A and B can be obtained. A description of the mechanism that makes it possible to obtain only the mixed film and a description of the appropriate position of the top face of each of the openings 12a and 13a will be given below with reference to Fig. 2.

The travel of the vapor released from the opening 13a of the deposition source 13 to the downstream side in the conveying direction T is restricted by the deposition-preventing plate 15_{B} within a region defined by a line D_{B}. Meanwhile, the travel of the vapor released from the opening 12a of the deposition source 12 to the downstream side in the conveying direction T is restricted by the opening side wall 12b within a region defined by a line D_{A}. The top face of the opening 12a is formed so that the deposition region defined by the line D_{A} on the surface of the glass substrate 14 can coincide with the deposition region defined by the line D_{B} on the surface of the glass substrate 14. To be more specific, the position of the top face of the opening 12a is determined in the following way. Draw a straight line passing through the tip of the deposition-preventing plate 15_{B} from the upper end of the opening 13a. The line thus drawn is the line D_{B}. Draw another straight line from the intersection of the line D_{B} with the glass substrate 14 so as to pass through the upper end of the opening 12a. The line thus drawn is the line D_{A}. The position of the top face of the opening 12a is determined so that the segment representing the top face of the opening 12a may be on the line D_{A}. This way of positioning the top face of the opening 12a makes the deposition region of the film-formation material A coincide with the deposition region of the film-formation material B on the downstream side of the glass substrate 14 (i.e., on the downstream-side portion within the deposition region R). As a consequence, the formation of a mono-content film containing either one of the film-formation materials A and B can be avoided, and only the mixed film containing both of the film-formation materials A and B can be formed.

Likewise, the travel of the vapor released from the opening 12a of the deposition source 12 to the upstream side in the conveying direction T is restricted by the deposition-preventing plate 15_{A} within a region defined by a line U_{A}. Meanwhile, the travel of the vapor released from the opening 13a of the deposition source 13 to the upstream side in the conveying direction T is restricted by the opening side wall 13b within a region defined by a line U_{B}. The top face of the opening 13a is formed so that the deposition region defined by the line U_{B} on the surface of the glass substrate 14 can coincide with the deposition region defined by the line U_{A} on the surface of the glass substrate 14. To be more specific, the position of the top face of the opening 13a is determined in the following way. Draw a straight line passing through the tip of the deposition-preventing plate 15_{A} from the upper end of the opening 12a. The line thus drawn is the line U_{A}. Draw another straight line from the intersection of the line U_{A} with the glass substrate 14 so as to pass through the upper end of the opening 13a. The line thus drawn is the line U_{B}. The position of the top face of the opening 13a is determined so that the segment representing the top face of the opening 13a is on the line U_{B}. This way of positioning the top face of the opening 13a makes the deposition region of the film-formation material A coincide with the deposition region of the film-formation material B on the upstream side of the glass substrate 14 (i.e., on the upstream-side portion within the deposition region R). As a consequence, the formation of a mono-content film containing either one of the film-formation materials A and B can be avoided, and only the mixed film containing both of the film-formation materials A and B can be formed.

The opening side walls 12b and 13b become barriers to shield some regions of the surface of the glass substrate 14 from the deposition of the vapors released from the opening 12a of the deposition source 12 and from the opening 13a of the deposition source 13. As a consequence, the opening side walls 12b and 13b prevent the formation of any mono-content film. The opening side walls 12b and 13b are formed integrally with their respective deposition sources 12 and 13, and therefore the temperatures of the opening side walls 12b and 13b are the same as those of their respective deposition sources 12 and 13. For this reason, in contrast to the screen 6 provided in Embodiment 1, the opening side walls 12b and 13b trap none of the film-formation materials A and B. Accordingly, the vapor of the film-formation materials A and B that are not trapped can be efficiently provided to the side of the glass substrate 14.

As has been described thus far, in the opening portion 12a of the deposition source 12 and in the opening portion 13a of the deposition source 13, their respective opening side walls 12b and 13b are extended. Accordingly, the formation of a mono-content film containing either one of the film-formation materials A and B can be avoided and the entire deposition region R of the glass substrate 14 can have only the mixed film containing both of the film-formation materials A and B.

In addition, the prevention of the formation of a mono-content film eliminates the necessity of elongating the distance between adjacent deposition chambers, so that the size of the apparatus as a whole can be made more compact. Moreover, although, in most of the cases, the top face of the opening of the deposition source is formed so as to be parallel to the glass substrate, the top face thus formed can easily be modified to adapt to this second embodiment by cutting the opening in the way described above.

### Embodiment 3

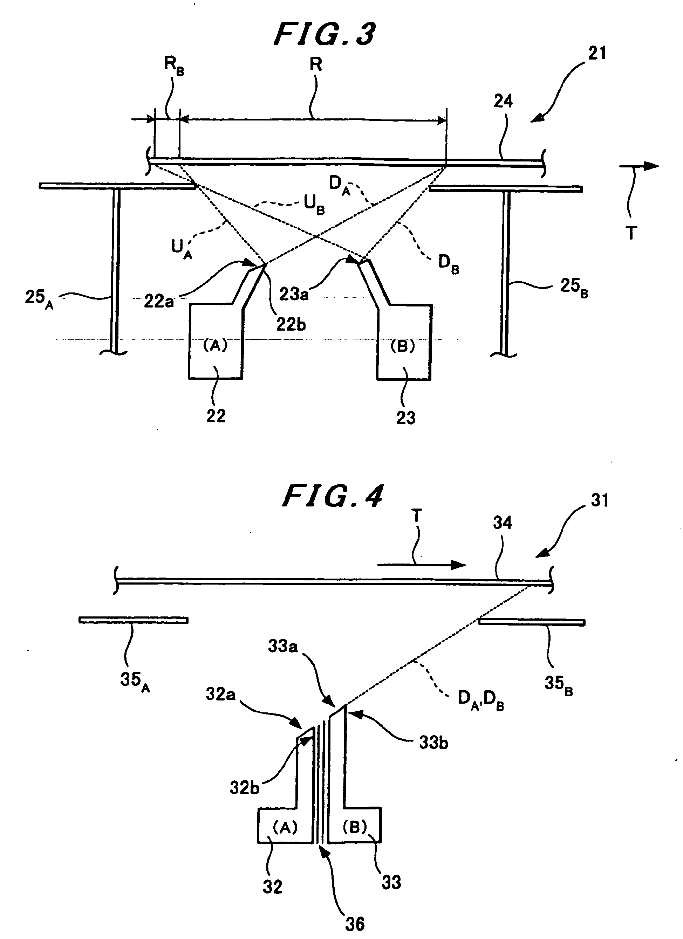

Fig. 3 is a schematic view illustrating an in-line film-formation apparatus according to a third embodiment of the present invention. Fig. 3 used for the description of this third embodiment illustrates, as in the cases of Embodiments 1 and 2, only a co-deposition chamber of all the multiple deposition chambers constituting the in-line film-formation apparatus.

The in-line film-formation apparatus of this third embodiment is a modified example of the apparatus of Embodiment 2 (illustrated in Fig. 2). The configuration of the apparatus of this third embodiment allows a mono-content film to be formed either on the upstream side or on the downstream side in the conveying direction T. To be more specific, the apparatus of this third embodiment allows a mono-content film to be formed on the upstream side in the conveying direction T.

As Fig. 3 shows, the in-line film-formation apparatus of this third embodiment has at least one co-deposition chamber 21, and the co-deposition chamber 21 includes two deposition sources 22 and 23 that store respectively film-formation materials A and B. Openings 22a and 23a are formed respectively in the deposition sources 22 and 23. Each of the openings 22a and 23a extends in the width directions of a glass substrate 24, which is perpendicular to the conveying direction T of the glass substrate 24. The openings 22a and 23a are arranged in parallel with each other and are disposed respectively on the upstream side and on the downstream side in the conveying direction T. Co-deposition is performed firstly by either evaporating or subliming the film-formation materials A and B stored respectively in the deposition sources 22 and 23. Then, the film-formation materials A and B, either evaporated or sublimed, are mixedly deposited, so as to form a mixed film, onto the glass substrate 24 that is conveyed in the conveying direction T. The length of each of the openings 22a and 23a in the width directions of the glass substrate 24, which is a direction perpendicular to the conveying direction T, is preferably equal to or longer than the width of the glass substrate 24.

Two deposition-preventing plates 25_{A} and 25_{B} (partition members) are disposed in the co-deposition chamber 21 so that the deposition-preventing plates 25_{A} and 25_{B} can partition the co-deposition chamber 21 respectively from its adjacent deposition chambers. The deposition-preventing plates 25_{A} and 25_{B} are placed so as to be separated away from the conveyed glass substrate 24, are placed in parallel to each other and are placed respectively at the upstream side and at the downstream side, in the conveying direction T, while interposing two deposition sources 22 and 23 in between. The in-line film-formation apparatus has multiple deposition chambers that are successively placed in the conveying direction T. Thus, the deposition-preventing plates 25_{A} and 25_{B} are provided to partition the deposition chambers, and prevent the vapor from the deposition sources of adjacent deposition chambers from being mixed together.

In Embodiment 2, one of the side walls of the opening of each of the two deposition sources is extended so as to serve as a restriction member. Of the two side walls of each of the two openings, the extended one is located on the side closer to the other opening. In this third embodiment, however, as Fig. 3 shows, the top face of only the opening 22a of the deposition source 22 is obliquely formed. The opening side wall 22b located on the side where the forming of a mono-content film needs to be avoided (in Fig. 3, on the downstream side in the conveying direction T) is extended. Thereby, only the opening side wall 22b serves as a restriction member.

Accordingly, the extending of the opening side wall 22b eliminates the possibility of forming such a mono-content film on the downstream-side portion within a deposition region R of the glass substrate 24. Thus, only the mixed film containing both of the film-formation materials A and B can be obtained. By contrast, on the upstream side of the deposition region R on the glass substrate 24, that is, a deposition region R_{B} on the glass substrate 24, a mono-content film is allowed to be formed.

In this third embodiment, as in the case of Embodiment 2, the travel of the vapor released from the opening 23a of the deposition source 23 to the downstream side in the conveying direction T is restricted by the deposition-preventing plate 25_{B} within a region defined by a line D_{B}. Meanwhile, the travel of the vapor released from the opening 22a of the deposition source 22 to the downstream side in the conveying direction T is restricted by the opening side wall 22b within a region defined by a line D_{A}. The top face of the opening 22a is formed so that the deposition region defined by the line D_{A} on the surface of the glass substrate 24 can coincide with the deposition region defined by the line D_{B} on the surface of the glass substrate 24. To be more specific, the position of the top face of the opening 22a is determined in the following way. Draw a straight line passing through the tip of the deposition-preventing plate 25_{B} from the upper end of the opening 23a. The line thus drawn is the line D_{B}. Draw another straight line from the intersection of the line D_{B} with the glass substrate 24 so as to pass through the upper end of the opening 22a. The line thus drawn is the line D_{A}. The position of the top face of the opening 22a is determined so that the segment representing the top face of the opening 22a may be on the line D_{A}. This way of positioning the top face of the opening 22a makes the deposition region of the film-formation material A coincide with the deposition region of the film-formation material B on the downstream side of the glass substrate 24 (i.e., on the downstream-side portion within the deposition region R) . As a consequence, the formation of a mono-content film containing either one of the film-formation materials A and B can be avoided, and only the mixed film containing both of the film-formation materials A and B can be formed.

On the other hand, the travel of the vapor released from the opening 22a of the deposition source 22 to the upstream side in the conveying direction T is restricted by the deposition-preventing plate 25_{A} within a region defined by a line U_{A}. Meanwhile, the travel of the vapor released from the opening 23a of the deposition source 23 to the upstream side in the conveying direction T is restricted by the deposition-preventing plate 25_{A} within a region defined by a line U_{B}. Accordingly, the deposition region R_{B} thus formed is included in the deposition region of the film-formation material B of the deposition source 23, but is not included in the deposition region of the film-formation material A of the deposition source 22. As a consequence, the film thus formed in the deposition region R_{B} becomes a mono-content film of only the film-formation material B.

The opening side wall 22b becomes a barrier to shield a region of the surface of the glass substrate 24 from the deposition of the vapor released from the opening 22a of the deposition source 22. As a consequence, the opening side wall 22b prevents the formation of a mono-content film only on the downstream side of the glass substrate 24. The opening side wall 22b is formed integrally with the deposition source 22. Accordingly, the temperature of the opening side wall 22b is the same as the temperature of the deposition source 22. For this reason, in contrast to the screen 6 provided in Embodiment 1, the opening side wall 22b traps no film-formation material A. Accordingly, the vapor of the film-formation material A that is not trapped can be efficiently provided to the side of the glass substrate 24. In addition, although, in most of the cases, the top face of the opening of the deposition source is formed so as to be parallel to the glass substrate, the top face thus formed can easily be modified to adapt to this third embodiment by cutting the opening in the way described above.

### Embodiment 4

Fig. 4 is a schematic view illustrating an in-line film-formation apparatus according to a fourth embodiment of the present invention. Fig. 4 used for the description of this fourth embodiment illustrates, as in the cases of Embodiments 1 to 3, only a co-deposition chamber of all the multiple deposition chambers constituting the in-line film-formation apparatus.

The in-line film-formation apparatus of this fourth embodiment has, as in the case of Embodiment 3 (illustrated in Fig. 3), a configuration that allows a mono-content film to be formed either on the upstream side or on the downstream side in the conveying direction T. To be more specific, the apparatus of this fourth embodiment allows a mono-content film to be formed on the upstream side in the conveying direction T.

As Fig. 4 shows, the in-line film-formation apparatus of this fourth embodiment has at least one co-deposition chamber 31, and the co-deposition chamber 31 includes two deposition sources 32 and 33 that store respectively film-formation materials A and B. Openings 32a and 33a are formed respectively in the deposition sources 32 and 33. Each of the openings 32a and 33a extends in the width directions of a glass substrate 34, which is perpendicular to the conveying direction T of the glass substrate 34. The openings 32a and 33a are arranged in parallel with each other and are disposed respectively on the upstream side and on the downstream side in the conveying direction T. Co-deposition is performed firstly by either evaporating or subliming the film-formation materials A and B stored respectively in the deposition sources 32 and 33. Then, the film-formation materials A and B, either evaporated or sublimed, are mixedly deposited, so as to form a mixed film, onto the glass substrate 34 that is conveyed in the conveying direction T. The length of each of the openings 32a and 33a in the width directions of the glass substrate 34, which is a direction perpendicular to the conveying direction T, is preferably equal to or longer than the width of the glass substrate 34.

Two deposition-preventing plates 35_{A} and 35_{B} (partition members) are disposed in the co-deposition chamber 31 so that the deposition-preventing plates 35_{A} and 35_{B} can partition the co-deposition chamber 31 respectively from its adjacent deposition chambers. The deposition-preventing plates 35_{A} and 35_{B} are placed so as to be separated away from the conveyed glass substrate 34, are placed in parallel to each other and are placed respectively at the upstream side and at the downstream side, in the conveying direction T, while interposing two deposition sources 32 and 33 in between. The in-line film-formation apparatus has multiple deposition chambers that are successively placed in the conveying direction T. Thus, the deposition-preventing plates 35_{A} and 35_{B} are provided to partition the deposition chambers, and prevent the vapor from the deposition sources of adjacent deposition chambers from being mixed together.

In Embodiment 3, the two deposition sources 22 and 23 are placed with a certain distance left in between. The deposition sources 32 and 33 of this fourth embodiment, however, are placed closely to each other with at least one thermal insulation plate 36 placed in between, as Fig. 4 shows. The top face of each of the opening 32a of the deposition source 32 and the opening 33a of the deposition source 33 is obliquely formed. Thereby, opening side walls 32b and 33b located on the side where the forming of a mono-content film needs to be avoided (in Fig. 4, on the downstream side in the conveying direction T) are extended, and thus both of the opening side walls 32b and 33b serve as restriction members.

Accordingly, the extending of the opening side walls 32b and 33b eliminates the possibility of forming such a mono-content film on the downstream-side portion within a deposition region of the glass substrate 34. Thus, only the mixed film containing both of the film-formation materials A and B can be obtained. By contrast, on the upstream side of the deposition region on the glass substrate 34, a mono-content film is allowed to be formed.

In this fourth embodiment, the travel of the vapor released from the opening 33a of the deposition source 33 to the downstream side in the conveying direction T is restricted by the opening side wall 33b within a region defined by a line D_{B}. Meanwhile, the travel of the vapor released from the opening 32a of the deposition source 32 to the downstream side in the conveying direction T is restricted by the opening side wall 32b within a region defined by a line D_{A}. The top faces of the openings 32a and 33a are formed so that the line D_{A} can coincide with the line D_{B}. Accordingly, the deposition region defined by the line D_{A} on the glass substrate 34 coincides with the deposition region defined by the line D_{B} on the glass substrate 34. To be more specific, the positions of the top faces of the openings 32a and 33a are determined in the following way. Draw a straight line passing through the tip of the deposition-preventing plate 35_{B} from the upper end of the opening 33a. The line thus drawn is the line D_{A} = D_{B}. The positions of the top faces of the openings 32a and 33a are determined so that the segments representing the top faces of the openings 32a and 33a may be on the line D_{A} = D_{B}. This way of positioning the top faces of the openings 32a and 33a makes the deposition region of the film-formation material A coincide with the deposition region of the film-formation material B on the downstream side of the glass substrate 34 (i.e., on the downstream-side portion within the deposition region). As a consequence, the formation of a mono-content film containing either one of the film-formation materials A and B can be avoided, and only the mixed film containing both of the film-formation materials A and B can be formed.

On the other hand, the travel of the vapor released from the opening 32a of the deposition source 32 to the upstream side in the conveying direction T and the travel of the vapor released from the opening 33a of the deposition source 33 to the upstream side in the conveying direction T are restricted by the deposition-preventing plate 35_{A}. Accordingly, there is formed, on the upstream side of the glass substrate 34, a region which is included in the deposition region of the film-formation material B of the deposition source 33, but which is not included in the deposition region of the film-formation material A of the deposition source 32. As a consequence, the film thus formed in the region on the upstream side becomes a mono-content film of only the film-formation material B.

The opening side walls 32b and 33b become barriers to shield a region of the surface of the glass substrate 34 both from the deposition of the vapor from the opening 32a of the deposition source 32 and from the deposition of the vapor from the opening 33a of the deposition source 33. As a consequence, the opening side walls 32b and 33b prevent the formation of a mono-content film only on the downstream side of the glass substrate 34. The opening side walls 32b and 33b are formed integrally respectively with the deposition sources 32 and 33. Accordingly, the temperatures of the opening side walls 32b and 33b are the same as those of the deposition sources 32 and 33, respectively. For this reason, in contrast to the screen 6 provided in Embodiment 1, the opening side walls 32b and 33b trap none of the film-formation materials A and B. Accordingly, the vapors of the film-formation materials A and B that are not trapped can be efficiently provided to the side of the glass substrate 34. In addition, although, in most of the cases, the top face of the opening of the deposition source is formed so as to be parallel to the glass substrate, the top face thus formed can easily be modified to adapt to this fourth embodiment by cutting the opening in the way described above.

In the configuration of this fourth embodiment, the thermal insulation plate 36 is provided between the deposition sources 32 and 33. Accordingly, even when there is a large difference between the temperature of the deposition source 32 and that of the deposition source 33 (for example, one of the deposition sources 32 and 33 has a temperature of 300°C while the other one has a temperature of 600°C), the two deposition sources 32 and 33 can be placed closely to each other. To put it other way, the thermal insulation plate 36 has a function of providing a heat gradient (thermal insulation layer) between the deposition sources 32 and 33. An appropriate heat gradient can be provided by increasing or decreasing the number of thermal insulation plates 36 in response to the magnitude of the difference in the temperature between the two deposition sources 32 and 33.

The present invention is suitable for an in-line film-formation apparatus and particularly for an in-line film-formation apparatus that is used to manufacture organic electroluminescence (EL) devices.

## Claims

1. An in-line film-formation apparatus including a plurality of deposition chambers at least one of which is a co-deposition chamber (1, 11, 21) that forms a mixed film by a co-deposition process of two different film-formation materials (A, B), in the co-deposition process the two different film-formation materials (A, B) being evaporated or sublimed and then the vapor of the evaporated or sublimed two film formation materials (A,B) being mixedly deposited, the plurality of deposition chambers being arranged in a conveying direction (T) in which a substrate (4, 14, 24) is conveyed, the deposition chambers thus arranged forming films successively onto the substrate (4, 14, 24) that is being conveyed, so as to form a multi-layered film onto the substrate (4, 14, 24), the in-line film-formation apparatus **characterized in that**
the co-deposition chamber (1, 11, 21) includes:
two deposition sources (2, 3, 12, 13, 22, 23) that respectively store the film-formation materials (A, B), the deposition sources (2, 3, 12, 13, 22, 23) respectively including openings (2a, 3a, 12a, 13a, 22a, 23a) each extending in the width directions of the substrate (4, 14, 24) which are perpendicular to the conveying direction (T), the openings (2a, 3a, 12a, 13a, 22a, 23a) being arranged in parallel with each other respectively on the upstream and downstream sides in the conveying direction (T);
two partition members (5_{A}, 5_{B}, 15_{A}, 15_{B}, 25_{A}, 25_{B}) that partition the co-deposition chamber (1, 11, 21) respectively from adjacent deposition chambers, the partition members (5_{A}, 5_{B}, 15_{A}, 15_{B}, 25_{A}, 25_{B}) being placed away from the conveyed substrate (4, 14, 24) and being placed in parallel with each other respectively on the upstream and downstream sides in the conveying direction (T) with the two deposition sources (2, 3, 12, 13, 22, 23) placed in between; and
a restriction member (6, 12b, 22b) that restricts vapor released from the upstream-side opening (2a, 12a, 22a) and deposited on the downstream side of the substrate (4, 14, 24) so that a downstream-side limit is set on a deposition region where the vapor is to be deposited, the deposition region with the downstream-side limit coinciding with a deposition region of vapor released from the downstream-side opening (3a, 13a, 23a) and deposited on the downstream side of the substrate (4, 14, 24), the partition member on the downstream side (5_{B}, 15_{B}, 25_{B}) setting a downstream-side limit on the deposition region of the vapor released from the downstream-side opening (3a, 13a, 23a), and
while the formation of a mono-content film containing either one of the two film-formation materials (A, B) is prevented on the downstream side of the substrate (4, 14, 24), only the mixed film is formed on the downstream side of the substrate (4, 14, 24).

2. The in-line film-formation apparatus according to claim 1, **characterized in that**
the restriction member (6) further restricts the vapor released from the downstream-side opening (3a) and deposited on the upstream side of the substrate (4) so that an upstream-side limit is set on the deposition region of the vapor released from the downstream-side opening (3a), and the deposition region of the vapor released from the downstream-side opening (3a) with the upstream-side limit coincides with a deposition region of vapor released from the upstream-side opening (2a) and deposited on the upstream side of the substrate (4) while the upstream-side partition member (5_{A}) sets an upstream-side limit on the deposition region of the vapor released from the upstream-side opening (2a), and
while the formation of a mono-content film containing either one of the two film-formation materials (A, B) is prevented also on the upstream side of the substrate (4), only the mixed film is formed on the upstream side of the substrate (4).

3. The in-line film-formation apparatus according to anyone of claims 1 and 2, **characterized by** comprising a screen (6) which is disposed between the two openings (2a, 3a) and which serves as the restriction member.

4. The in-line film-formation apparatus according to claim 3, **characterized in that** the screen (6) is placed so that the upper end of the screen (6) is on at least one of a first and a second lines (D_{A}, U_{B}) defined as follows:
the first line (D_{A}) which is drawn from a starting point through the farther one of the edges of the upstream-side opening (2a) from the downstream-side partition member (5_{B}), the starting point being an intersection of the substrate (4) with a line (D_{B}) passing through the tip of the downstream-side partition member (5_{B}) and the farther one of the edges of the downstream-side opening (3a) from the downstream-side partition member (5_{B}) ; and
the second line (U_{B}) which is drawn from a starting point through the farther one of the edges of the downstream-side opening (3a) from the upstream-side partition member (5_{A}), the starting point being an intersection of the substrate (4) with a line (U_{A}) passing through the tip of the upstream-side partition member (5_{A}) and the farther one of the edges of the upstream-side opening (2a) from the upstream-side partition member (5_{A}).

5. The in-line film-formation apparatus according to anyone of claims 1 and 2, **characterized in that** -- -
at least one of opening side walls (12b, 22b, 13b) defined as follows is extended so as to serve as the restriction member:
one of the two opening side walls (12b, 22b) of the upstream-side opening (12a, 22a), the one being located closer to the downstream-side opening (13a, 23a); and
one of the two opening side walls (13b) of the downstream-side opening (13a), the one being located closer to the upstream-side opening (12a).

6. The in-line film-formation apparatus according to claim 5, **characterized in that** the opening side wall (12b, 22b, 13b) is formed with the top face of at least one (12a, 22a, 13a) of the openings (12a, 13a, 22a, 23a) obliquely formed so as to accomplish any one of a first coincidence and a second coincidence defined as follows:
the first coincidence being between the position of the top face of the upstream-side opening (12a, 22a) and a line (D_{A}) which is drawn from a starting point through the upper end of the upstream-side opening (12a, 22a), the starting point being an intersection of the substrate (14, 24) with a line (D_{B}) passing through the upper end of the downstream-side opening (13a, 23a) and the tip of the downstream-side partition member (15_{B}, 25_{B}) ; and
the second coincidence being between the position of the top face of the downstream-side opening (13a) and a line (U_{B}) which is drawn from a starting point through the upper end of the downstream-side opening (13a), the starting point being an intersection of the substrate (14) with a line (U_{A}) passing through the upper end of the upstream-side opening (12a) and the tip of the upstream-side partition member (15_{A}).

7. The in-line film-formation apparatus according to claim 6, **characterized in that** the top face is obliquely formed by cutting the opening (12a, 13a, 22a).

8. An in line film formation apparatus including a plurality of deposition chambers at least one of which is a co-deposition chamber (31) that forms a mixed film by a co-deposition process of two different film-formation materials (A, B), in the co-deposition process the two different film-formation materials (A, B) being evaporated or sublimed and then the vapor of the evaporated or sublimed two film-formation materials (A, B) being mixedly deposited, the plurality of deposition chambers being arranged in a conveying direction (T) in which a substrate (34) is conveyed, the deposition chambers thus arranged forming films successively onto the substrate (34) that is being conveyed, so as to form a multi-layered film onto the substrate (34), the in-line film-formation apparatus **characterized in that**
the co-deposition chamber (31) includes:
two deposition sources (32, 33) that respectively store the film-formation materials (A, B), the deposition sources (32, 33) respectively including openings (32a, 33a) each extending in the width directions of the substrate (34) which are perpendicular to the conveying direction (T), the openings (32a, 33a) being arranged in parallel with each other respectively on the upstream and downstream sides in the conveying direction (T);
two partition members (35_{A}, 35_{B}) that partition the co-deposition chamber (31) respectively from adjacent deposition chambers, the partition members (35_{A}, 35_{B}) being placed away from the conveyed substrate (34) and being placed in parallel to each other respectively on the upstream and downstream sides in the conveying direction (T) with the two deposition sources (32, 33) placed in between; and
restriction members (32b, 33b) that restrict vapor released from a first-side one of the openings (32a, 33a) on a first side of the upstream and downstream sides and deposited on a second side of the upstream and downstream sides of the substrate (32) so that a second-side limit is set on a deposition region where the vapor is to be deposited, the deposition region with the second side limit coinciding with a deposition region of vapor released from a second-side one of the openings (32a, 33a) on the second side and deposited on the second side of the substrate (34), a second one of the partition members (35_{A}, 35_{B}) on the second side setting a second-side limit on the deposition region of the vapor released from the second-side one of the openings (32a, 33a),
opening side walls (32b, 33b), extending on the second sides of the respective openings (32a, 33a), are formed as the restriction members by obliquely forming the top faces of the openings (32a, 33a) so that the top faces of the openings (32a, 33a) are on a line (D_{A}, D_{B}) which passes through the upper end of the second-side one of the openings (32a, 33a) and the tip of the second one of the partition members (35_{A}, 35_{B}), and
while the formation of a mono-content film containing either one of the two-film-formation materials (A, B) is prevented on the second side of the substrate (34), only the mixed film is formed on the second side of the substrate (34).

9. The in-line film-formation apparatus according to claim 8, **characterized by** further comprising:
a thermal insulation member (36) provided between the two deposition sources (32, 33), **characterized in that**
the two deposition sources (32, 33) are placed closely to each other.

## Patentansprüche

1. Reihen-Filmbildungsvorrichtung, umfassend eine Vielzahl von Ablagerungskammern, von denen mindestens eine eine Co-Ablagerungskammer (1, 11, 21) ist, die einen gemischten Film durch einen Co-Ablagerungsprozess von zwei verschiedenen filmbildenden Materialien (A, B) bildet, wobei in dem Co-Ablagerungsprozess die zwei verschiedenen filmbildenden Materialien (A, B) verdampft oder sublimiert werden und der Dampf der verdampften oder sublimierten zwei filmbildenden Materialien (A, B) dann gemischt abgelagert wird, wobei die Vielzahl von Ablagerungskammern in einer Förderrichtung (T), in der ein Substrat (4, 14, 24) befördert wird, angeordnet ist, wobei die so angeordneten Ablagerungskammern auf dem beförderten Substrat (4, 14, 24) sukzessive Filme bilden, um einen mehrschichtigen Film auf dem Substrat (4, 14, 24) zu bilden, wobei die Reihen-Filmbildungsvorrichtung **dadurch gekennzeichnet ist, dass**
die Co-Ablagerungskammer (1, 11, 21) umfasst:
zwei Ablagerungsquellen (2, 3, 12, 13, 22, 23), die die filmbildenden Materialien (A, B) entsprechend speichern, wobei die Ablagerungsquellen (2, 3, 12, 13, 22, 23) jeweils Öffnungen (2a, 3a, 12a, 13a, 22a, 23a) umfassen, die sich jeweils in die senkrecht zur Förderrichtung (T) verlaufende Breitenrichtung des Substrats (4, 14, 24) erstrecken, wobei die Öffnungen (2a, 3a, 12a, 13a, 22a, 23a) auf der stromaufwärtigen beziehungsweise der stromabwärtigen Seite in der Förderrichtung (T) parallel zueinander angeordnet sind;
zwei Unterteilungselemente (5_{A}, 5_{B}, 15_{A}, 15_{B}, 25_{A}, 25_{B}), die jeweils die Co-Ablagerungskammer (1, 11, 21) von angrenzenden Ablagerungskammern unterteilen, wobei die Unterteilungselemente (5_{A}, 5_{B}, 15_{A}, 15_{B}, 25_{A}, 25_{B}) von dem beförderten Substrat (4, 14, 24) weg platziert sind und parallel zueinander auf der stromaufwärtigen beziehungsweise der stromabwärtigen Seite in der Förderrichtung (T), mit den dazwischen angeordneten zwei Ablagerungsquellen (2, 3, 12, 13, 22, 23), platziert sind; und
ein Begrenzungselement (6, 12b, 22b), das den von der stromaufwärtsseitigen Öffnung (2a, 12a, 22a) freigegebenen und auf der stromabwärtigen Seite des Substrats (4, 14, 24) abgelagerten Dampf so beschränkt, dass eine stromabwärtsseitige Begrenzung auf einem Ablagerungsbereich, in dem der Dampf abgelagert werden soll, festgelegt ist, wobei der Ablagerungsbereich mit der stromabwärtsseitigen Begrenzung mit einem Ablagerungsbereich von durch die stromabwärtsseitige Öffnung (3a, 13a, 23a) freigegebenen und auf der stromabwärtigen Seite des Substrats (4, 14, 24) abgelagerten Dampf übereinstimmt, wobei das Unterteilungselement auf der stromabwärtigen Seite (5_{B}, 15_{B}, 25_{B}) eine stromabwärtsseitige Begrenzung in dem Ablagerungsbereich für den von der stromabwärtsseitigen Öffnung (3a, 13a, 23a) freigegebenen Dampf festlegt, und
während die Bildung eines Mono-Inhalts-Films, der einen der zwei filmbildenden Materialien (A, B) enthält, an der stromabwärtigen Seite des Substrats (4, 14, 24) verhindert wird, nur der gemischte Film auf der stromabwärtigen Seite des Substrats (4, 14, 24) gebildet wird.

2. Reihen-Filmbildungsvorrichtung nach Anspruch 1, **dadurch gekennzeichnet, dass**
das Begrenzungselement (6) den von der stromabwärtsseitigen Öffnung (3a) freigegebenen und auf der stromaufwärtigen Seite des Substrats (4) abgelagerten Dampf ferner so beschränkt, dass eine stromaufwärtsseitige Begrenzung in dem Ablagerungsbereich des von der stromabwärtsseitigen Öffnung (3a) freigegebenen Dampfs festgelegt ist, und der Ablagerungsbereich des von der stromabwärtsseitigen Öffnung (3a) mit der stromaufwärtsseitigen Begrenzung freigegebenen Dampfs mit einem Ablagerungsbereich von Dampf übereinstimmt, der von der stromaufwärtsseitigen Öffnung (2a) freigegeben und an der stromaufwärtigen Seite des Substrats (4) abgelagert ist, während das stromaufwärtsseitige Unterteilungselement (5_{A}) eine stromaufwärtsseitige Begrenzung in dem Ablagerungsbereich des von der stromaufwärtsseitigen Öffnung (2a) freigegebenen Dampfs festlegt, und
während die Bildung eines Mono-Inhalts-Films, der einen der zwei filmbildenden Materialien (A, B) enthält, auch auf der stromaufwärtigen Seite des Substrats (4) verhindert wird, nur der gemischte Film auf der stromaufwärtigen Seite des Substrats (4) gebildet wird.

3. Reihen-Filmbildungsvorrichtung nach einem der vorhergehenden Ansprüche 1 oder 2, **gekennzeichnet durch** einen Schirm (6), der zwischen den zwei Öffnungen (2a, 3a) angeordnet ist und als das Begrenzungselement dient.

4. Reihen-Filmbildungsvorrichtung nach Anspruch 3, **dadurch gekennzeichnet, dass** der Schirm (6) so angeordnet ist, dass das obere Ende des Schirms (6) auf einer ersten und/oder einer zweiten Geraden (D_{A}, U_{B}) liegt, die wie nachfolgend definiert sind:
die erste Gerade (D_{A}), die von einem Startpunkt durch die von dem stromabwärtsseitigen Unterteilungselement (5_{B}) weiter entfernte Kante der stromaufwärtsseitigen Öffnung (2a) gezogen wird, wobei der Startpunkt ein Schnittpunkt des Substrats (4) mit einer Geraden (D_{B}) ist, die durch die Spitze des stromabwärtsseitigen Unterteilungselements (5_{B}) und durch die von dem stromabwärtsseitigen Unterteilungselement (5_{B}) weiter entfernte Kante der stromabwärtsseitigen Öffnung (3a) verläuft; und
die zweite Gerade (U_{B}), die von einem Startpunkt durch die von dem stromaufwärtsseitigen Unterteilungselement (5_{A}) weiter entfernte Kante der stromabwärtsseitigen Öffnung (3a) gezogen wird, wobei der Startpunkt ein Schnittpunkt des Substrats (4) mit einer Geraden (U_{A}) ist, die durch die Spitze des stromaufwärtsseitigen Unterteilungselements (5_{A}) und die von dem stromaufwärtsseitigen Unterteilungselement (5_{A}) weiter entfernte Kante der stromaufwärtsseitigen Öffnung (2a) verläuft.

5. Reihen-Filmbildungsvorrichtung nach einem der Ansprüche 1 oder 2, **dadurch gekennzeichnet, dass**
mindestens eine der nachfolgend definierten Öffnungsseitenwände (12b, 22b, 13b) verlängert ist, um so als das Begrenzungselement zu dienen:
eine der zwei Öffnungsseitenwände (12b, 22b) der stromaufwärtsseitigen Öffnung (12a, 22a), nämlich diejenige, die näher an der stromabwärtsseitigen Öffnung (13a, 23a) angeordnet ist; und
eine der zwei Öffnungsseitenwände (13b) der stromabwärtsseitigen Öffnung (13a), nämlich diejenige, die näher an der stromaufwärtsseitigen Öffnung (12a) angeordnet ist.

6. Reihen-Filmbildungsvorrichtung nach Anspruch 5, **dadurch gekennzeichnet, dass** die Öffnungsseitenwand (12b, 22b, 13b) mit der Oberseite mindestens einer (12a, 22a, 13a) der Öffnungen (12a, 13a, 22a, 23a) schräg gebildet ist, um so eine erste Übereinstimmung und/oder eine zweite Übereinstimmung, die nachfolgend definiert sind, zu erreichen:
die erste Übereinstimmung, die zwischen der Position der Oberseite der stromaufwärtsseitigen Öffnung (12a, 22a) und einer Gerade (D_{A}) vorliegt, die von einem Startpunkt durch das obere Ende der stromaufwärtsseitigen Öffnung (12a, 22a) gezogen wird, wobei der Startpunkt ein Schnittpunkt des Substrats (14, 24) mit einer Geraden (D_{B}) ist, die durch das obere Ende der stromabwärtsseitigen Öffnung (13a, 23a) und die Spitze des stromabwärtsseitigen Unterteilungselements (15_{B}, 25_{B}) verläuft; und
die zweite Übereinstimmung, die zwischen der Position der Oberseite der stromabwärtsseitigen Öffnung (13a) und einer Geraden (U_{B}) vorliegt, die von einem Startpunkt durch das obere Ende der stromabwärtsseitigen Öffnung (13a) gezogen wird, wobei der Startpunkt ein Schnittpunkt des Substrats (14) mit einer Geraden (U_{A}) ist, die durch das obere Ende der stromaufwärtsseitigen Öffnung (12a) und die Spitze des stromaufwärtsseitigen Unterteilungselements (15_{A}) verläuft.

7. Reihen-Filmbildungsvorrichtung nach Anspruch 6, **dadurch gekennzeichnet, dass** die Oberseite durch Abschneiden der Öffnung (12a, 13a, 22a) schräg gebildet ist.

8. Reihen-Filmbildungsvorrichtung, umfassend eine Vielzahl von Ablagerungskammern, von denen mindestens eine eine Co-Ablagerungskammer (31) ist, die einen gemischten Film durch einen Co-Ablagerungsprozess von zwei verschiedenen filmbildenden Materialien (A, B) bildet, wobei in dem Co-Ablagerungsprozess die zwei verschiedenen filmbildenden Materialien (A, B) verdampft oder sublimiert werden und der Dampf der verdampften oder sublimierten zwei filmbildenden Materialien (A, B) dann gemischt abgelagert wird, wobei die Vielzahl von Ablagerungskammern in einer Förderrichtung (T), in der ein Substrat (34) befördert wird, angeordnet ist, wobei die so angeordneten Ablagerungskammern auf dem beförderten Substrat (34) sukzessive Filme bilden, um einen mehrschichtigen Film auf dem Substrat (34) zu bilden, wobei die Reihen-Filmbildungsvorrichtung **dadurch gekennzeichnet ist, dass**
die Co-Ablagerungskammer (31) umfasst:
zwei Ablagerungsquellen (32, 33), die die filmbildenden Materialien (A, B) entsprechend speichern, wobei die Ablagerungsquellen (32, 33) jeweils Öffnungen (32a, 33a) umfassen, die sich jeweils in die senkrecht zur Förderrichtung (T) verlaufenden Breitenrichtung des Substrats (34) erstrecken, wobei die Öffnungen (32a, 33a) auf der stromaufwärtigen beziehungsweise der stromabwärtigen Seite in der Förderrichtung (T) parallel zueinander angeordnet sind;
zwei Unterteilungselemente (35_{A}, 35_{B}) die jeweils die Co-Ablagerungskammer (31) von angrenzenden Ablagerungskammern entsprechend unterteilen, wobei die Unterteilungselemente (35_{A}, 35_{B}) von dem beförderten Substrat (34) weg platziert sind und parallel zueinander auf der stromaufwärtigen beziehungsweise der stromabwärtigen Seite in der Förderrichtung (T), mit den dazwischen angeordneten zwei Ablagerungsquellen (32, 33), platziert sind; und
Begrenzungselemente (32b, 33b), die von einer der Öffnungen (32a, 33a) einer ersten Seite auf eine erste Seite der stromaufwärtigen und der stromabwärtigen Seite freigegebenen und auf einer zweiten Seite der stromaufwärtigen und der stromabwärtigen Seite des Substrats (32) abgelagerten Dampf so beschränken, dass eine zweite Seitenbegrenzung in einem Ablagerungsbereich, in dem der Dampf abgelagert werden soll, festgelegt ist, wobei der Ablagerungsbereich mit der zweiten Seitenbegrenzung mit einem Ablagerungsbereich von Dampf übereinstimmt, der von einer der Öffnungen (32a, 33a) einer zweiten Seite auf der zweiten Seite freigegeben ist und sich auf der zweiten Seite des Substrats (34) ablagert, wobei ein zweites der Unterteilungselemente (35_{A}, 35_{B}) auf der zweiten Seite eine zweite Seitenbegrenzung in dem Ablagerungsbereich des von der zweiten Seite der Öffnungen (32a, 33a) freigegebenen Dampfs festlegt,
Öffnungsseitenwände (32b, 33b), die sich auf den zweiten Seiten der entsprechenden Öffnungen (32a, 33a) erstrecken und die als Begrenzungselemente durch schräges Bilden der Oberseiten der Öffnungen (32a, 33a) so gebildet sind, dass die Oberseiten der Öffnungen (32a, 33a) auf einer Geraden (D_{A}, D_{B}) liegen, die durch das obere Ende der zweiten Seite der Öffnungen (32a, 33a) und die Spitze des zweiten der Unterteilungselemente (35_{A}, 35_{B}) verläuft, und
während die Bildung eines Mono-Inhalts-Films, der eines der zwei filmbildenden Materialien (A, B) enthält, auf der zweiten Seite des Substrats (34) verhindert wird, nur der gemischte Film auf der zweiten Seite des Substrats (34) gebildet wird.

9. Reihen-Filmbildungsvorrichtung nach Anspruch 8, **dadurch gekennzeichnet, dass** sie ferner umfasst:
ein thermisches Isolierelement (36), das zwischen den zwei Ablagerungsquellen (32, 33) vorgesehen ist, **dadurch gekennzeichnet, dass**
die zwei Ablagerungsquellen (32, 33) nahe beieinander angeordnet sind.

## Revendications

1. Dispositif de formation de film en ligne incluant une pluralité de chambres de dépôt au moins l'une d'entre elles étant une chambre de co-dépôt (1, 11, 21) qui forme un film mixte par un procédé de co-dépôt de deux matériaux de formation de film différents (A, B) dans le procédé de co-dépôt, les deux matériaux de formation de film différents (A, B) étant évaporés ou sublimés et ensuite la vapeur des deux matériaux de formation de film évaporés ou sublimés (A, B) étant déposée de façon mélangée, la pluralité de chambres de dépôt étant agencées dans une direction d'acheminement (T) dans laquelle un substrat (4, 14, 24) est acheminé, les chambres de dépôt ainsi agencées formant des films successivement sur le substrat (4, 14, 24) qui est en cours d'acheminement, de manière à former un film multicouche sur le substrat (4, 14, 24), l'appareil de formation de film en ligne étant **caractérisé en ce que** la chambre de co-dépôt (1, 11, 21) inclut :
deux sources de dépôt (2, 3, 12, 13, 22, 23) qui mémorisent respectivement les matériaux de formation de film (A, B), les sources de dépôt (2, 3, 12, 13, 22, 23) incluant respectivement des ouvertures (2a, 3a, 12a, 13a, 22a, 23a) s'étendant chacune dans les directions de la largeur du substrat (4, 14, 24) qui sont perpendiculaires à la direction d'acheminement (T), les ouvertures (2a, 3a, 12a, 13a, 22a, 23a) étant disposées en parallèle les unes par rapport aux autres respectivement sur les côtés amont et aval dans la direction d'acheminement (T);
deux éléments de séparation (5_{A}, 5_{B}, 15_{A}, 15_{B}, 25_{A}, 25_{A}) qui séparent la chambre de co-dépôt (1, 11, 21) respectivement de chambres de dépôt adjacentes, les éléments de séparation (5_{A}, 5_{B}, 15_{A}, 15_{B}, 25_{A}, 25_{B}) étant placés à distance du substrat acheminé (4, 14, 24) et étant placés en parallèle les uns par rapport aux autres, respectivement sur les côtés amont et aval dans la direction d'acheminement (T) avec les deux sources de dépôt (2, 3, 12, 13, 22, 23) placées entre eux, et
un élément de restriction (6, 12b, 22b) qui limite la vapeur libérée par l'ouverture du côté amont (2a, 12a, 22a) et déposée sur le côté aval du substrat (4, 14, 24) de telle sorte qu'une limite du côté aval est fixée sur une région de dépôt où la vapeur doit être déposée, la région de dépôt avec la limite du côté aval coïncidant avec une région de dépôt de vapeur libérée de l'ouverture du côté aval (3a, 13a, 23a) et déposée sur le côté aval du substrat (4, 14, 24), l'élément de séparation sur le côté aval (5_{B}, 15_{B}, 25_{B}) fixant une limite du côté aval sur la région de dépôt de la vapeur libérée de l'ouverture du côté aval (3a, 13a, 23a), et
alors que la formation d'un film mono-contenu contenant l'un ou l'autre des deux matériaux de formation de film (A, B) est empêchée sur le côté aval du substrat (4, 14, 24), uniquement le film mixte est formé sur le côté aval du substrat (4, 14, 24).

2. Dispositif e formation de film en ligne selon la revendication 1, **caractérisé en ce que**
l'élément de restriction (6) limite en outre la vapeur libérée de l'ouverture du côté aval (3a) et déposée sur le côté amont du substrat (4) de sorte qu'une limite côté amont est fixée sur la région de dépôt de la vapeur libérée de l'ouverture du côté aval (3a), et la région de dépôt de la vapeur libérée de l'ouverture du côté aval (3a) avec la limite du côté amont coïncide avec une région de dépôt de vapeur libérée de l'ouverture du côté amont (2a) et déposée sur le côté amont du substrat (4) alors que l'élément de partition du côté amont (5_{A}) fixe une limite du côté amont sur la région de dépôt de la vapeur libérée de l'ouverture du côté amont (2a), et
alors que la formation d'un film mono-contenu contenant l'un ou l'autre des deux matériaux de formation de film (A, B) est empêchée également sur le côté amont du substrat (4), uniquement le film mixte est formé sur le côté amont du substrat (4).

3. Dispositif de formation de film en ligne selon l'une quelconque des revendications 1 et 2, **caractérisé en ce qu'**il comporte un écran (6) qui est disposé entre les deux ouvertures (2a, 3a) et qui sert d'élément de restriction.

4. Dispositif de formation de film en ligne selon la revendication 3, **caractérisé en ce que** l'écran (6) est placé de telle sorte que l'extrémité supérieure de l'écran (6) est sur au moins l'une d'une première et d'une deuxième ligne (D_{A}, U_{B}) définies comme suit:
la première ligne (D_{A}) qui est tirée à partir d'un point de départ à travers le plus éloigné des bords de l'ouverture du côté amont (2a) de l'élément de séparation du côté aval (5_{B}), le point de départ étant une intersection du substrat (4) avec une ligne (D_{B}) passant par la pointe de l'élément de séparation du côté aval (5_{B}) et le plus éloigné des bords de l'ouverture du côté aval (3a) de l'élément de séparation du côté aval (5_{B}), et
la deuxième ligne (U_{B}) qui est tirée à partir d'un point de départ à travers le plus éloigné des bords de l'ouverture du côté aval (3a) de l'élément de séparation du côté amont (5_{A}), le point de départ étant une intersection du substrat (4) avec une ligne (U_{A}) passant par la pointe de l'élément de séparation du côté amont (5_{A}) et le plus éloigné des bords de l'ouverture du côté amont (2a) de l'élément de séparation du côté amont (5_{A}).

5. Dispositif de formation de film en ligne selon l'une quelconque des revendications 1 et 2, **caractérisé en ce que**
au moins l'une des parois latérales d'ouverture (12b, 22b, 13b) définies comme suit est prolongée de façon à servir d'élément de restriction :
l'une des deux parois latérales d'ouverture (12b, 22b) de l'ouverture du côté amont (12a, 22a), l'une étant située plus près de l'ouverture du côté aval (13a, 23a), et
l'un des deux parois latérales d'ouverture (13b) de l'ouverture du côté aval (13a), l'une étant située plus près de l'ouverture du côté amont (12a).

6. Dispositif de formation de film en ligne selon la revendication 5, **caractérisé en ce que** la paroi latérale d'ouverture (12b, 22b, 13b) est formée avec la face supérieure d'au moins l'une (12a, 22a, 13a) des ouvertures (12a, 13a, 22a, 23a) formées obliquement de manière à accomplir l'une quelconque d'une première coïncidence et d'une seconde coïncidence définies comme suit:
la première coïncidence étant située entre la position de la face supérieure de l'ouverture du côté amont (12a, 22a) et une ligne (D_{A}) qui est tirée à partir d'un point de départ à travers l'extrémité supérieure de l'ouverture du côté amont (12a, 22a), le point de départ étant une intersection du substrat (14, 24) avec une ligne (D_{B}) passant par l'extrémité supérieure de l'ouverture du côté aval (13a, 23a) et la pointe de l'élément de séparation du côté aval (15_{B}, 25_{B}), et
la seconde coïncidence étant comprise entre la position de la face supérieure de l'ouverture du côté aval (13a) et une ligne (U_{B}) qui est tirée à partir d'un point de départ à travers l'extrémité supérieure de l'ouverture du côté aval (13a), le point de départ étant une intersection du substrat (14) avec une ligne (U_{A}) passant par l'extrémité supérieure de l'ouverture du côté amont (12a) et la pointe de l'élément de séparation du côté amont (15_{A}).

7. Dispositif de formation de film en ligne selon la revendication 6, **caractérisé en ce que** la face supérieure est formée de manière oblique en découpant l'ouverture (12a, 13a, 22a).

8. Dispositif de formation de film en ligne incluant une pluralité de chambres de dépôt au moins l'une d'entre elles étant une chambre de co-dépôt (31) qui forme un film mixte par un procédé de co-dépôt de deux matériaux de formation de film différents (A, B), dans le procédé de co-dépôt des deux matériaux de formation de film différents (A, B) étant évaporés ou sublimés et ensuite la vapeur des deux films de formation de matériaux évaporés ou sublimés (A, B) étant déposée de façon mélangée, la pluralité de chambres de dépôt étant disposées dans une direction d'acheminement (T) dans laquelle un substrat (34) est acheminée, les chambres de dépôt ainsi disposées formant des films successivement sur le substrat (34) qui est en cours d'acheminement, de manière à former un film multicouche sur le substrat (34), l'appareil de formation de film en ligne étant **caractérisé en ce que**
la chambre de co-dépôt (31) comporte :
deux sources de dépôt (32, 33) qui stockent respectivement les matériaux de formation de film (A, B), les sources de dépôt (32, 33) incluant respectivement des ouvertures (32a, 33a) chacune s'étendant dans les directions de la largeur du substrat (34) qui sont perpendiculaires à la direction d'acheminement (T), les ouvertures (32a, 33a) étant disposées en parallèle les unes par rapport aux autres respectivement sur les côtés amont et aval dans la direction d'acheminement (T);
deux éléments de séparation (35_{A}, 35_{B}) qui séparent la chambre de co-dépôt (31) respectivement de chambres de dépôt adjacentes, les éléments de séparation (35_{A}, 35_{B}) étant placés à distance du substrat acheminé (34) et étant placés en parallèle les uns par rapport aux autres respectivement sur les côtés amont et aval dans la direction d'acheminement (T) avec les deux sources de dépôt (32, 33) placées entre eux, et
les éléments de restriction (32b, 33b) qui limitent la vapeur libérée à partir d'un premier côté des ouvertures (32a, 33a) sur un premier côté des côtés amont et aval et déposés sur un second côté des côtés amont et aval du substrat (32) de telle sorte qu'une limite de second côté est fixée sur une région de dépôt où la vapeur doit être déposée, la région de dépôt avec la limite de second côté coïncidant avec une région de dépôt de vapeur libérée à partir d'un second côté des ouvertures (32a, 33a) sur le second côté et déposée sur le second côté du substrat (34), un second des éléments de séparation (35_{A}, 35_{B}) sur le second côté fixant une limite de second côté sur la région de dépôt de la vapeur libérée du second côté des ouvertures (32a, 33a),
les parois latérales d'ouverture (32b, 33b), s'étendant sur les seconds côtés des ouvertures respectives (32a, 33a), sont formées comme des éléments de restriction en formant obliquement les faces supérieures des ouvertures (32a, 33a) de sorte que les faces supérieures des ouvertures (32a, 33a) sont sur une ligne (D_{A}, D_{B}) qui passe à travers l'extrémité supérieure du second côté des ouvertures (32a, 33a) et la pointe du second des éléments de séparation (35_{A}, 35_{H}), et
alors que la formation d'un film mono-contenu contenant l'un ou l'autre des deux matériaux de formation de film (A, B) est empêchée sur le second côté du substrat (34), uniquement le film mixte est formé sur le second côté du substrat (34).

9. Dispositif de formation de film en ligne selon la revendication 8, caractérisé ce qu'il comporte :
un élément d'isolation thermique (36) prévu entre les deux sources de dépôt (32, 33), caractérisé en ce
les deux sources de dépôt (32, 33) sont placées à proximité étroite l'une de l'autre.
